# EUROPÄISCHE PATENTSCHRIFT

(11) **EP 1 844 521 B1**
(45) Veröffentlichungstag und Bekanntmachung des Hinweises auf die Patenterteilung: **09.09.2009**
(21) Anmeldenummer: 06706553.2
(22) Anmeldetag: 01.02.2006
(51) Int. Cl.: H01Q 1/24

(54) **ANTENNENKOPPLER MIT ANSCHLAGWINKEL**
ANTENNA COMBINER WITH A TRY SQUARE
DISPOSITIF DE COUPLAGE D'ANTENNES COMPRENANT UNE EQUERRE DE BUTEE

(30) Priorität: 04.02.2005 DE 102005005261
(43) Veröffentlichungstag der Anmeldung: 17.10.2007
(73) Patentinhaber: Rohde & Schwarz GmbH & Co. KG, 81671 München (DE)
(72) Erfinder: RAIMANN, Markus, 86875 Waalhaupten (DE)
(74) Vertreter: Körfer, Thomas
(86) Internationale Anmeldenummer: PCT/EP2006/000876
(87) Internationale Veröffentlichungsnummer: WO 2006/082039

(56) Entgegenhaltungen:
- EP-A- 0 887 233
- EP-A- 0 993 209
- WO-A-20/05055361
- DE-C1- 10 056 638
- DE-U1- 20 014 882
- US-B1- 6 223 033
- PATENT ABSTRACTS OF JAPAN Bd. 2000, Nr. 04, 31. August 2000 (2000-08-31) -& JP 2000 013073 A (ANDO ELECTRIC CO LTD), 14. Januar 2000 (2000-01-14)
- PATENT ABSTRACTS OF JAPAN Bd. 2000, Nr. 04, 31. August 2000 (2000-08-31) -& JP 2000 009779 A (ANDO ELECTRIC CO LTD), 14. Januar 2000 (2000-01-14)

## Beschreibung

Die Erfindung betrifft einen Antennenkoppler zum Testen von Sendern und/oder Empfängern, insbesondere von Mobiltelefonen oder Geräten, die nach dem Blue-Tooth-Standard arbeiten.

Aus der DE 197 32 639 C1 ist ein Antennenkoppler zum Testen von Mobiltelefonen bekannt. Bei dem bekannten Antennenkoppler ist ein Aufnahmeelement für ein Mobiltelefon auf einer Leiterplatte befestigt. Auf der Leiterplatte ist in Streifenleitertechnik eine Stabantenne ausgebildet, die insbesondere als Dipol-Antenne wirkt. Eine wesentliche Eigenschaft des Antennenkopplers ist der Kopplungsfaktor, welcher das Verhältnis der empfangenen Leistung in Bezug auf die abgestrahlte Gesamtleistung angibt. Da die bekannte Anordnung äußerst sensibel auf Lageänderungen der Antenne des Mobiltelefons reagiert, ist der Kopplungsfaktor für jeden an dem Aufnahmeelement fixierte Typ von Mobiltelefon unterschiedlich.

Weiterhin ist aus der DE 101 29 408 A1 ein Antennenkoppler zum Testen von mobilen Sendern und/oder Empfängern, insbesondere Mobiltelefonen, bekannt. Der Antennenkoppler weist ein Aufnahmeelement und/oder eine Auflagefläche für den mobilen Sender und/oder Empfänger und zumindest ein Antennenelement auf. Dabei ist das Antennenelement als räumlich zumindest im wesentlichen geschlossene Schleife ausgebildet.

Nachteilig an den oben beschriebenen Antennenkopplern ist dabei insbesondere, daß Mobiltelefone unterschiedlicher Bauformen nicht so in den jeweiligen Aufnahmeelementen angeordnet werden können, daß eine zufriedenstellende Ankoppelung an den Antennenkoppler gewährleistet ist. In der Folge treten hohe Koppelungsdämpfungen auf, die das Testen der Mobiltelefone erschweren oder sogar ganz unmöglich machen.

Aufgabe der Erfindung ist es daher, einen Antennenkoppler zu schaffen, der so ausgebildet ist, daß beliebige Sender und/oder Empfänger, i.e. beispielsweise Mobiltelefone verschiedener Bauart, optimal zu Testzwecken darauf angeordnet werden können.

Die Aufgabe wird durch einen Antennenkoppler mit dem Merkmalen des Anspruchs 1 gelöst.

Vorteilhafterweise ist auf der Anlagefläche ein Anschlagwinkel angeordnet, welcher das einfache Einlegen beliebig geformter Mobiltelefone in reproduzierbaren Positionen ermöglicht, ohne durch Schieflagen die Koppelung zu verringern.

Vorteilhafte Weiterbildungen der Erfindung sind in den Unteransprüchen angegeben.

Die Erfindung wird nachfolgend unter Bezugnahme auf die Zeichnung näher erläutert. In der Zeichnung zeigt:
- Fig. 1: ein Ausführungsbeispiel eines Antennenkopplers gemäß dem Stand der Technik in einer Draufsicht;
- Fig. 2A-C: schematische Ansichten der Komponenten eines Antennenkopplers,
- Fig. 3: eine Ansicht eines ersten Mobiltelefons in dem Antennenkoppler,
- Fig. 4: eine Ansicht eines zweiten Mobiltelefons in dem Antennenkoppler,
- Fig. 5: eine Ansicht eines dritten Mobiltelefons in dem Antennenkoppler, und
- Fig. 6: eine Ansicht des dritten Mobiltelefons in dem Antennenkoppler in einer zweiten Position.

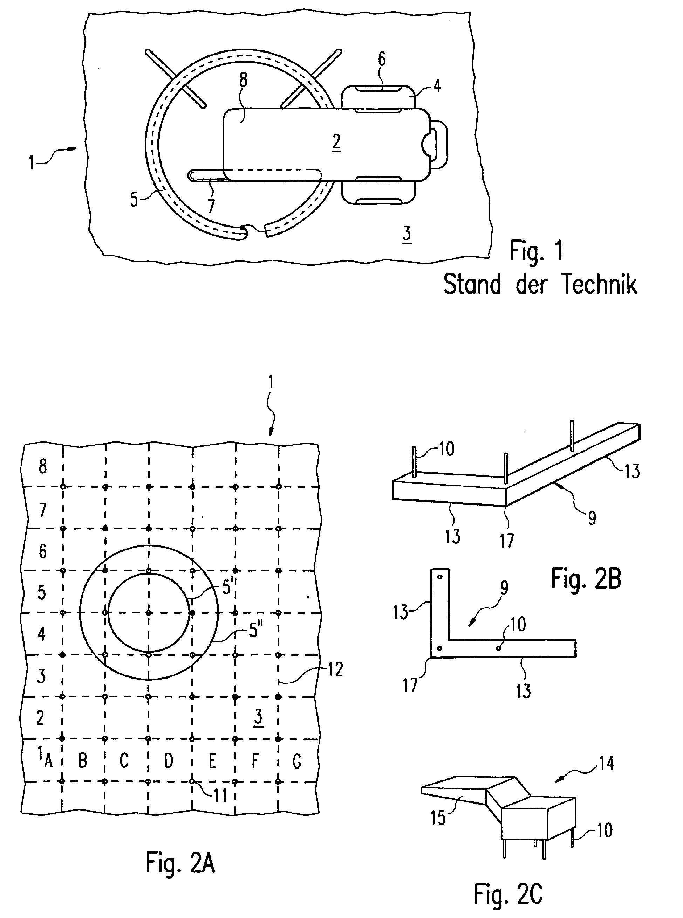

Fig. 1 zeigt zum besseren Verständnis der erfindungsgemäßen Maßnahmen einen Antennenkoppler 1 nach einem Ausführungsbeispiel gemäß dem Stand der Technik in einer Draufsicht. Der Antennenkoppler 1 dient zum Testen eines Mobiltelefons 2. Hierzu wird das Mobiltelefon 2 mittels eines auf einer Auflagefläche 3 befestigten Aufnahmeelements 4 des Antennenkopplers 1 über einem Antennenelement 5 positioniert. Das Antennenelement 5 ist dabei vorzugsweise als räumlich im wesentlichen geschlossene Schleife ausgebildet. Es kann aber auch z. B. als Streifenleistungs - Stabantenne oder -Schlitzantenne ausgeführt sein. Durch das Aufnahmeelement 4 soll dabei eine definierte Position vorgegeben und eine Verschiebung des Mobiltelefons 2 während der durchgeführten Messungen verhindert werden. Zur Befestigung des Mobiltelefons 2 umfaßt das Aufnahmeelement 4 hierzu insbesondere mehrere Arretierelemente 6.

Eine Antenne 7 des Mobiltelefons 2, die im Inneren des Mobiltelefons 2 mit unterbrochener Linie dargestellt ist, ist durch die Befestigung oberhalb des Antennenelements 5 angeordnet. Da die genaue Position der Antenne 7 von außen nicht ohne weiteres beurteilt werden kann, ist auch eine exakt zentrierte Anordnung der Antenne 7 über dem Antennenelement 5 nur schwer, d.h. nur mittels eines aufwendigen Abgleichs, möglich. Erschwert wird die Situation, wenn Mobiltelefone 2 getestet werden sollen, bei denen die Antenne 7 vollständig innerhalb des Gehäuses 8 des Mobiltelefons 2 untergebracht ist. Außerdem ist es umständlich, wenn für verschiedene Mobiltelefone 2 eine präzise räumlich Justage durchgeführt werden muß.

Ein weiteres Problem besteht darin, daß das Aufnahmeelement 4 nur für Mobiltelefone 2 geeignet ist, die eine bestimmte Breite zwischen den Arretierelementen 6 nicht überschreiten. Da heute jedoch viele Mobiltelefone 2 bedingt durch eine Fülle von zusätzlichen Funktionen wie eingebaute Kameras etc. eine abweichende Form aufweisen, zum Klappen oder Drehen sind, können solche Mobiltelefone nicht oder nur unzureichend in das Aufnahmeelement 4 eingelegt werden, wodurch sich die Koppelungswerte drastisch verschlechtern und ein Testen des Geräts u.U. unmöglich wird.

Die vorliegende Erfindung vermeidet die genannten Probleme, indem ein Antennenkoppler 1 vorgeschlagen wird, mit welchem beliebige Mobiltelefone 2 zuverlässig getestet werden können. Die Komponenten eines Ausführungsbeispiels eines erfindungsgemäß ausgestalteten Antennenkopplers 1 sind dabei in Fig. 2A und 2B stark schematisiert dargestellt.

In Fig. 2B ist ein in einer Perspektive und von unten gezeigter Anschlagwinkel 9 vorgesehen, welcher auf der in Fig. 2A gezeigten Auflagefläche 3 des Antennenkopplers 1 mit Hilfe von Stiften 10 angeordnet werden kann. Der Anschlagwinkel 9 weist dabei zwei im Wesentlichen zueinander senkrechte Schenkel 13 auf, welche unterschiedlich lang sein können und als Auflage für das zu testende Mobiltelefon 2 dienen. Die Stifte 10 sind an einer der Auflagefläche 3 zugewandten Seite des Anschlagwinkels 9 angeordnet und können in Öffnungen 11 in der Auflagefläche 3 des Antennenkopplers 1 eingesteckt werden. Die Öffnungen 11 sind dabei in Form eines rechtwinkligen Rasters 12 in der Anlagefläche 3 angeordnet. Die Abstände der Öffnungen 11 zueinander sind dabei in den beiden Raumrichtungen im Wesentlichen jeweils gleich groß. Mit 5' und 5" sind Markierungen an der Oberseite der Auflagefläche 3 bezeichnet, die mit der Lage der schleifenförmigen Antennenelemente 5 unterhalb der Auflagefläche 3 korrespondieren.

Durch die Verstellmöglichkeit des Anschlagwinkels 9 auf dem Raster 12 können beliebig geformte Mobiltelefone 2 in den Antennenkoppler 1 eingelegt sowie reproduzierbare Positionen für einzelne Modelle durch eine geeignete Wahl von Beschriftungen festgelegt werden. Hierzu kann beispielsweise eine Rechtswertachse (x-Achse) mit Buchstaben und eine Hochwertachse (y-Achse) mit Zahlen beschriftet sein, damit eine einfache Auffindung von vorbestimmten Positionen möglich ist. Als Referenzpunkt dient dabei vorzugsweise der Stift 10, welcher an einer Ecke 17 des Anschlagwinkels 9 fixiert ist. Die Beschriftung ist in Fig. 2A beispielhaft dargestellt, in den folgenden Figuren wurde aus Gründen der Übersichtlichkeit darauf verzichtet.

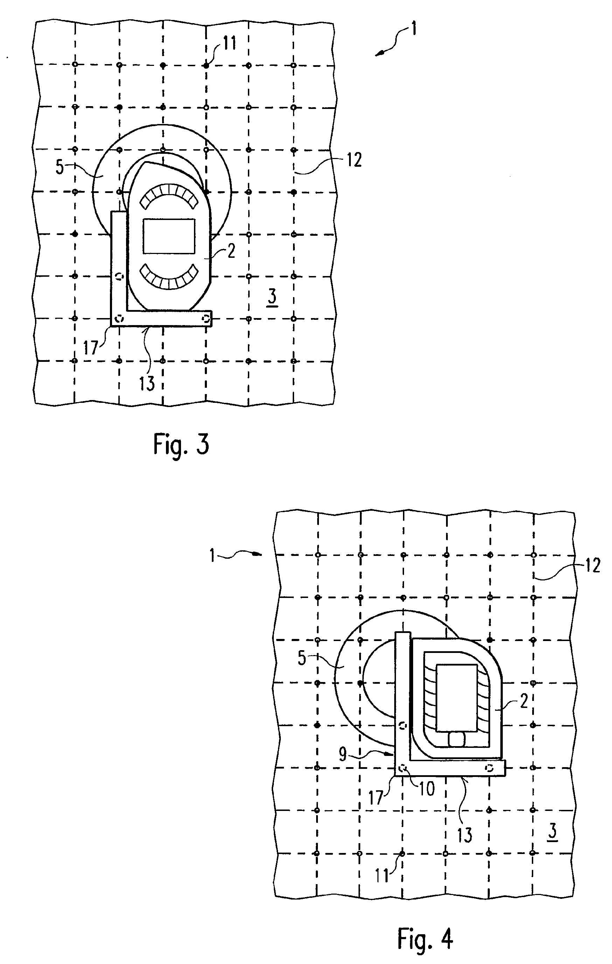

Beispiele für die Positionierung von verschieden geformten Mobiltelefonen 2 in dem Anschlagwinkel 9 auf der Anlagefläche 3 sind in den folgenden Fig. 3 bis 5 beispielhaft schematisch dargestellt. Die Position der Stifte 10 des Anschlagwinkels 9 ist jeweils gestrichelt dargestellt, um die Einsteckpositionen zu verdeutlichen.

Die in den Fig. 3 und 4 dargestellten Mobiltelefone weisen dabei jeweils eine breite, von herkömmlichen Mobiltelefonen 2 abweichende Form auf, haben keine sichtbare Antenne 7 und sind daher mit herkömmlichen Antennenkopplern 1 schlecht oder gar nicht zu testen. In dem Antennenkoppler 1 sind sie jedoch in einfacher Weise sicher einlegbar. Ist die Position nicht optimal, wie beispielsweise in Fig. 4, kann die Lage des Anschlagwinkels 9 durch Umstecken in einfacher Weise geändert werden, so daß eine bessere Koppelung erzielt wird, indem der Anschlagwinkel 9 mit den in den Öffnungen 11 steckenden Stiften 10 herausgezogen und beispielsweise eine Position weiter links wieder eingesteckt wird. Durch einen geeigneten Abstand der Öffnungen 11 zueinander und die passende Abstimmung des Abstandes der Stifte 10 an dem Anschlagwinkel 9 kann sichergestellt werden, daß stets eine Position mit ausreichender Koppelung für jeden Typ von Mobiltelefon 2 gefunden werden kann.

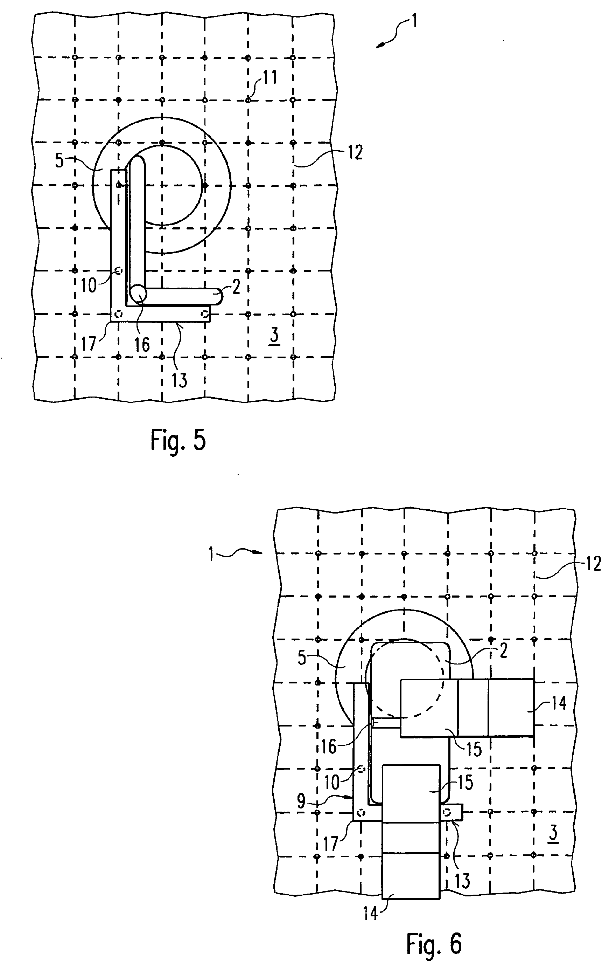

In Fig. 5 ist ein klappbares Mobiltelefon 2 dargestellt, welches mit Hilfe des Antennenkopplers 1 und des Anschlagwinkels 9 ebenfalls in einfacher Weise getestet werden kann. Um die Stabilität des seitlich liegenden Mobiltelefons 2 zu erhöhen und auch, um ein Zusammenklappen des Mobiltelefons 2 durch ein oftmals federbeaufschlagtes Scharnier 16 zu verhindern, ist es jedoch auch möglich, das Mobiltelefon 2 aufgeklappt auf die Auflagefläche 3 zu legen und durch geeignete Maßnahmen zu verhindern, daß es zusammenklappt.

Hierfür können ein oder mehrere Niederhalter 14 vorgesehen sein. Ein entsprechender Niederhalter 14 ist beispielhaft in Fig. 2C dargestellt. Auch der Niederhalter 14 weist Stifte 10 auf, um auf die Anlagefläche 3 aufsteckbar zu sein, sowie einen gewinkelten Arm 15, welcher das Mobiltelefon 2 auf die Auflagefläche 3 andrückt.

So kann das Mobiltelefon 2, wie aus Fig. 6 ersichtlich, aufgeklappt in den Anschlagwinkel 9 eingelegt und mit einem oder zwei Niederhaltern 14 so fixiert werden, daß es sich während des Meßvorgangs nicht zusammenklappen kann. Duch die Stifte 10 sind auch die Niederhalter 14 in ihrer Position beliebig veränderbar, so daß das Mobiltelefon 2 optimal an die Auflagefläche 3 angedrückt werden kann.

Der erfindungsgemäß ausgestaltete Antennenkoppler 1 ist eine drehbare Ausführung des Anschlagwinkels 9. Hierzu umfaßt der Anschlagwinkel 9 nur den als Referenzpunkt dienenden Stift 10, welcher an der Ecke 17 des Anschlagwinkels 9 angeordnet ist, so daß der Stift 10 in eines der Löcher 11 eingesteckt und der Anschlagwinkel 9 dann um diesen Stift 10 in eine bevorzugte Position gedreht werden kann. Dadurch ergeben sich weitere optimierte Positionen mit verbesserter Koppelung für unterschiedlich geformte Typen von Mobiltelefonen 2. Zum Ablesen der Winkelstellung des Anschlagwinkels 9 kann eine Skala auf der Auflagefläche 3 angebracht werden.

Die Erfindung ist nicht auf das beschriebene Ausführungsbeispiel beschränkt. Insbesondere eignet sich der Antennenkoppler zum Testen von beliebigen Sendern und/oder Empfängern bzw. Sende- und/oder Empfangsgeräten, wobei eine bevorzugte Anwendung im Testen von Mobiltelefonen 2 liegt.

## Patentansprüche

1. Antennenkoppler (1) zum Testen von mobilen Sendern und/oder Empfängern, insbesondere Mobiltelefonen (2), mit einer Auflagefläche (3) für den mobilen Sender und/oder Empfänger und zumindest einem Antennenelement (5), wobei auf der Auflagefläche (3) ein Anschlagwinkel (9) angeordnet ist,
**dadurch gekennzeichnet,**
**dass** der Anschlagwinkel (9) an einer der Auflagefläche (3) zugewandten seite nur einen einzehnen Stift (10) aufweist, wobei der Anschlagwinkel (9) um den einzelnen Stift (10) in eine beliebige Winkelstellung drehbar ist.

2. Antennenkoppler nach Anspruch 1,
**dadurch gekennzeichnet,**
**dass** der Anschlagwinkel (9) zwei rechtwinklig zueinander angeordnete, gleich lange oder unterschiedlich lange Schenkel (13) aufweist.

3. Antennenkoppler nach Anspruch 1 oder 2,
**dadurch gekennzeichnet,**
**dass** der Anschlagwinkel (9) in seiner Position entlang eines Rasters (12) in zwei Raumrichtungen versetzbar angeordnet ist.

4. Antennenkoppler nach Anspruch 1,
**dadurch gekennzeichnet,**
**dass** der Stift (10) in Öffnungen (11) in der Auflagefläche (3) einsteckbar ist.

5. Antennenkoppler nach Anspruch 4,
**dadurch gekennzeichnet,**
**dass** die Öffnungen (11) an Kreuzungspunkten eines auf der Auflagefläche (3) ausgebildeten Rasters (12) liegen.

6. Antennenkoppler nach Anspruch 5,
**dadurch gekennzeichnet,**
**dass** das Raster (12) rechtwinklig ausgebildet ist.

7. Antennenkoppler nach einem der Ansprüche 4 bis 6,
**dadurch gekennzeichnet,**
**dass** die Abstände der Öffnungen (11) im Raster (12) konstant sind.

8. Antennenkoppler nach Anspruch 7,
**dadurch gekennzeichnet,**
**dass** die Abstände der Öffnungen (11) im Raster (12) in beiden Raumrichtungen ungefähr gleich groß sind.

9. Antennenkoppler nach einem der Ansprüche 1 bis 8,
**dadurch gekennzeichnet,**
**dass** zumindest ein Niederhalter (14) vorgesehen ist.

10. Antennenkoppler nach Anspruch 9,
**dadurch gekennzeichnet,**
**dass** der zumindest eine Niederhalter (14) Stifte (10) aufweist.

11. Antennenkoppler nach Anspruch 10,
**dadurch gekennzeichnet,**
**dass** der zumindest eine Niederhalter (14) mit Stiften (10) in Öffnungen (11) der Auflagefläche (3) einsteckbar ist.

12. Antennenkoppler nach einem der Ansprüche 9 bis 11,
**dadurch gekennzeichnet,**
**dass** der zumindest eine Niederhalter (14) einen Arm (15) aufweist.

13. Antennenkoppler nach Anspruch 12,
**dadurch gekennzeichnet,**
**dass** der zumindest eine Niederhalter (14) mittels des Arms (15) zum Andrücken des mobilen Senders und/oder Empfängers, insbesondere des Mobiltelefons (2), auf der Auflagefläche (3) geeignet ist.

14. Antennenkoppler nach Anspruch 1,
**dadurch gekennzeichnet,**
**dass** der einzelne Stift (10) an einer Ecke (17) des Anschlagwinkels (9) ausgebildet ist.

15. Antennenkoppler nach Anspruch 1,
**dadurch gekennzeichnet,**
**dass** zumindest zwei Stifte (10) an dem Anschlagwinkel (9) ausgebildet sind, wodurch der Anschlagwinkel (9) rotationsfest an der Auflagefläche (3) fixiert ist.

## Claims

1. An antenna coupler (1) for testing mobile transmitters and/or receivers, in particular mobile telephones (2), with a support surface (3) for the mobile transmitter and/or receiver and at least one antenna element (5), wherein an angled mounting bracket (9) is disposed on the support surface (3),
**characterised in that**,
on a side facing towards the support surface (3), the angled mounting bracket (9) provides only a single pin (10), wherein the angled mounting bracket (9) is rotatable about the single pin (10) into any required angular position.

2. The antenna coupler according to claim 1,
**characterised in that**
the angled mounting bracket (9) provides two arms (13) of the same length or different length disposed at right angles to one another.

3. The antenna coupler according to claim 1 or 2,
**characterised in that**
the angled mounting bracket (9) is arranged in a displaceable manner in two spatial directions in its position along a raster (12).

4. The antenna coupler according to claim 1,
**characterised in that**
the pin (10) can be plugged into openings (11) in the support surface (3).

5. The antenna coupler according to claim 4,
**characterised in that**
the openings (11) are disposed at crossing points of a raster (12) formed on the support surface (3).

6. The antenna coupler according to claim 5,
**characterised in that**
the raster (12) is formed in a rectangular manner.

7. The antenna coupler according to any one of claims 4 to 6,
**characterised in that**
the spacing distances between the openings (11) in the raster (12) are constant.

8. The antenna coupler according to claim 7,
**characterised in that**
the spacing distances between the openings (11) in the raster (12) are of approximately the same magnitude in both spatial directions.

9. The antenna coupler according to any one of claims 1 to 8,
**characterised in that**
at least one holding clip (14) is provided.

10. The antenna coupler according to claim 9,
**characterised in that**
the at least one holding clip (14) provides pins (10).

11. The antenna coupler according to claim 10,
**characterised in that**
the at least one holding clip (14) can be plugged with pins (10) into openings (11) of the support surface (3).

12. The antenna coupler according to any one of claims 9 to 11,
**characterised in that**
the at least one holding clip (14) provides an arm (15).

13. The antenna coupler according to claim 12,
**characterised in that**
the at least one holding clip (14) is suitable by means of the arm (15) for pressing down the mobile transmitter and/or receiver, in particular the mobile telephone (2), on the support surface (3).

14. The antenna coupler according to claim 1,
**characterised in that**
the single pin (10) is formed at one corner (17) of the angled mounting bracket (9).

15. The antenna coupler according to claim 1,
**characterised in that**
at least two pins (10) are formed on the angled mounting bracket (9), through which the angled mounting bracket (9) is fixed in a rotationally rigid manner on the support surface (3).

## Revendications

1. Dispositif coupleur d'antennes (1) pour tester des émetteurs et/ou récepteurs mobiles, notamment des téléphones mobiles (2), comprenant une surface d'appui (3) pour l'émetteur et/ou le récepteur mobile, et au moins un élément d'antenne (5), une cornière de butée (9) étant agencée sur la surface d'appui (3),
**caractérisé en ce que** la cornière de butée (9) présente sur un côté dirigé vers la surface d'appui (3), seulement une seule broche (10) individuelle, la cornière de butée (9) pouvant être tournée autour de ladite une broche individuelle (10) dans une position angulaire quelconque.

2. Dispositif coupleur d'antennes selon la revendication 1,
**caractérisé en ce que** la cornière de butée (9) comporte deux ailes (13) agencées perpendiculairement l'une à l'autre, et d'une longueur égale ou différente.

3. Dispositif coupleur d'antennes selon la revendication 1 ou 2,
**caractérisé en ce que** la cornière de butée (9) est agencée dans sa position en pouvant être déplacée le long d'un quadrillage (12), dans deux directions de l'espace.

4. Dispositif coupleur d'antennes selon la revendication 1,
**caractérisé en ce que** la broche (10) peut être enfichée dans des ouvertures (11) de la surface d'appui (3).

5. Dispositif coupleur d'antennes selon la revendication 4,
**caractérisé en ce que** les ouvertures (11) se situent au niveau des points d'intersection d'un quadrillage (12) formé sur la surface d'appui (3).

6. Dispositif coupleur d'antennes selon la revendication 5,
**caractérisé en ce que** le quadrillage (12) est de configuration orthogonale.

7. Dispositif coupleur d'antennes selon l'une des revendications 4 à 6,
**caractérisé en ce que** les distances d'espacement des ouvertures (11) dans le quadrillage (12) sont constantes.

8. Dispositif coupleur d'antennes selon la revendication 7,
**caractérisé en ce que** les distances d'espacement des ouvertures (11) dans le quadrillage (12) sont sensiblement de même grandeur dans les deux directions de l'espace.

9. Dispositif coupleur d'antennes selon l'une des revendications 1 à 8,
**caractérisé en ce qu'**il est prévu au moins un dispositif de maintien en appui (14).

10. Dispositif coupleur d'antennes selon la revendication 9,
**caractérisé en ce que** ledit au moins un dispositif de maintien en appui (14) comporte des broches (10).

11. Dispositif coupleur d'antennes selon la revendication 10,
**caractérisé en ce que** ledit au moins un dispositif de maintien en appui (14) peut être enfiché, avec des broches (10), dans des ouvertures (11) de la surface d'appui (3).

12. Dispositif coupleur d'antennes selon l'une des revendications 9 à 11,
**caractérisé en ce que** ledit au moins un dispositif de maintien en appui (14) présente un bras (15).

13. Dispositif coupleur d'antennes selon la revendication 12,
**caractérisé en ce que** ledit au moins un dispositif de maintien en appui (14) est adapté à appliquer, au moyen du bras (15), l'émetteur et/ou le récepteur mobile, notamment le téléphone mobile (2), sur la surface d'appui (3).

14. Dispositif coupleur d'antennes selon la revendication 1,
**caractérisé en ce que** l'unique broche individuelle (10) est formée à un coin de la cornière de butée (9).

15. Dispositif coupleur d'antennes selon la revendication 1,
**caractérisé en ce qu'**au moins deux broches (10) sont formées sur la cornière de butée (9), ce qui conduit à une fixation bloquée en rotation de la cornière de butée (9) sur la surface d'appui (3).
